# EUROPÄISCHE PATENTSCHRIFT

(11) **EP 4 386 412 B1**
(45) Veröffentlichungstag und Bekanntmachung des Hinweises auf die Patenterteilung: **08.04.2026**
(21) Anmeldenummer: 22213918.0
(22) Anmeldetag: 15.12.2022
(51) Int. Cl.: G01R 33/28, G01R 33/38, G01R 33/3815

(54) **MAGNETRESONANZSYSTEM MIT WÄRMESPEICHER IN DER ÄUSSEREN VAKUUMKAMMER**
MAGNETIC RESONANCE SYSTEM WITH HEAT SINK IN AN OUTER VACUUM CHAMBER
SYSTÈME DE RÉSONANCE MAGNÉTIQUE AVEC ACCUMULATEUR DE CHALEUR DANS LA CHAMBRE À VIDE EXTERNE

(43) Veröffentlichungstag der Anmeldung: 19.06.2024
(73) Patentinhaber: Siemens Healthineers AG, 91301 Forchheim (DE)
(72) Erfinder: Dr. Biber, Stephan, 91056 Erlangen (DE)
(74) Vertreter: Siemens Healthineers Patent Attorneys

(56) Entgegenhaltungen:
- GB-A- 2 420 858
- US-A1- 2011 007 445
- US-A1- 2011 056 218
- US-A1- 2015 255 977
- US-A1- 2015 346 299

## Beschreibung

Die vorliegende Erfindung betrifft ein Magnetresonanzsystem mit einer supraleitenden Magnetspuleneinrichtung, einer äußeren Vakuumkammer, in der die supraleitende Magnetspuleneinrichtung angeordnet ist, und einer Lasteinrichtung zum Herunterrampen der supraleitenden Magnetspuleneinrichtung, indem elektrischer Strom von der Magnetspuleneinrichtung in die Lasteinrichtung eingeleitet wird. Darüber hinaus betrifft die vorliegende Erfindung ein Verfahren zum Betreiben eines solchen Magnetresonanzsystems.

Moderne Magnetresonanzsysteme (kurz MR-Systeme) werden meist als "trockene MR-Systeme" mit geringem Helium-Inhalt realisiert, um Kosten zu sparen und von Helium unabhängig zu werden. Dazu ist es unerlässlich, dass sich trockene MR-Magneten im Falle eines Strom- oder Kühlungsausfalls selbst herunterrampen (d. h. Strom auskoppeln, um das Magnetfeld herunterzufahren) können, um einen so genannten "Quench" (Übergang des Supraleiters vom supraleitenden in den normalleitenden Zustand infolge Überschreitung der Sprungtemperatur) zu verhindern. Bei dem Herunterrampen wird die Energie, die im Magnetfeld gespeichert ist, aus dem Magneten herausgeleitet und als Wärme freigesetzt. Insbesondere wird die Energie nicht innerhalb des Kryoschilds (so genannte "4K-Ebene") deponiert, wo es viel länger dauern würde, die Energie wieder zu entziehen. Vielmehr wird die Energie in einen außerhalb des Magneten beziehungsweise außerhalb der äußeren Vakuumkammer (OVC) gelegenen Wärmespeicher abgegeben. Dazu wird der Strom, der zunächst widerstandslos in dem Supraleiter fließt, aus dem Magneten herausgeführt und über Leitungsdioden/Widerstände geleitet, um so die magnetische beziehungsweise elektrische Energie in Form von Wärmeenergie an eine Lasteinrichtung (RDL: Run down load) abzugeben. Die Lasteinrichtung kann aus kostengünstigem Material mit hoher Wärmekapazität (z. B. Aluminium) oder als "hybrider Wärmespeicher" (das Material vollzieht einen Phasenübergang bei der Wärmespeicherung, z. B. Paraffin) realisiert werden.

Für Magneten mit zunehmender Feldstärke (> 1,5 T) sind aber Aluminiumspeicher verhältnismäßig groß und schwer. Bei 3 T-Magneten wären beispielsweise 200 bis 300 kg Aluminium nötig, um die Energie des Feldes (8 bis 15 MJ) aufzunehmen und gleichzeitig die Temperatur der Lasteinrichtung (RDL: Run Down Load) unter 70 °C (kritische Berührtemperatur für Servicetechniker) zu halten.

Diese großen Aluminiummassen sind nachteilig, weil sie viel Platz am Magneten erfordern, die für Elektronik benötigt wird. Aufgrund des erhöhten Gewichts wird der Transport schwer. Aus Zugänglichkeitsgründen muss die Masse in der Regel asymmetrisch verteilt werden, was zu einem veränderten dynamischen Vibrationsverhalten (Floor born vibrations) führen kann.

Ein Kaltkopf für ein MRT-System zur Kühlung der supraleitenden Magnetspulen ist beispielsweise in der Druckschrift DE 11 2016 000 535 T5 beschrieben.

Aus US 2015 / 346 299 A1 ein supraleitendes MRT-Magnetsystem vom kryofreien Typ offenbart. Das Magnetsystem ist dazu ausgebildet, den Zustand von Systemkomponenten zu überwachen und im Falle eines vorhersehbaren Quench den supraleitenden Magneten bei jeder gewünschten Entladespannung zu entladen.

Aus GB 2 420 858 A sind supraleitende Magnete bekannt, die eine primäre supraleitende Magnetspulenschaltung und eine komplementäre Sekundärspulenschaltung aufweist, die gemeinsam Magnetfelder erzeugen.

Aus US 2011 / 056 218 A1 ist eine Vorrichtung zu einem Abführen von Energie für einen kryogen gekühlten supraleitenden Magneten bekannt.

Die Aufgabe der vorliegenden Erfindung besteht somit darin, eine verbesserte Möglichkeit zu schaffen, Energie aus supraleitenden Spulen eines Magnetresonanzsystems herauszuleiten. Erfindungsgemäß wird diese Aufgabe durch ein Magnetresonanzsystem gemäß Anspruch 1 mit einer supraleitenden Magnetspuleneinrichtung gelöst, wobei das Magnetresonanzsystem eine äußere Vakuumkammer, in der die supraleitende Magnetspuleneinrichtung angeordnet ist, aufweist. Das Magnetresonanzsystem kann beispielsweise als Kernspintomograph ausgebildet sein. Es besitzt supraleitende Magnetspulen, um beispielsweise Feldstärken von mehr als 1,5 T mit verhältnismäßig geringem Energieaufwand herstellen zu können. Hierzu müssen die Magnetspulen beispielsweise auf 4K herabgekühlt werden. Zu diesem Zweck befinden sich die supraleitenden Spulen in der Regel in einem so genannten Kryoschild, welches seinerseits in einer äußeren Vakuumkammer (OVC) angeordnet ist. Zwischen der äußeren Vakuumkammer und dem Kryoschild ist in der Regel Vakuum vorgesehen, um einen Wärmetransport von außen nach innen zu den gekühlten, supraleitenden Magnetspulen größtenteils zu verhindern.

Außerdem besitzt das Magnetresonanzsystem eine erste Lasteinrichtung zum Herunterrampen der supraleitenden Magnetspuleneinrichtung, indem elektrischer Strom von der Magnetspuleneinrichtung in die erste Lasteinrichtung eingeleitet wird. Die erste Lasteinrichtung weist in der Regel mehrere Dioden oder Widerstände auf, mit denen der in den Magnetspulen fließende Strom in Wärme umgewandelt werden kann. Dies bedeutet, dass beim Herunterrampen der Strom bewusst aus den supraleitenden Magnetspulen der Magnetspuleneinrichtung herausgeleitet wird, um das Magnetfeld abzubauen und die Energie aus der Magnetspuleneinrichtung zu entfernen. Das Herunterrampen (Englisch: Ramp Down oder Run Down) entspricht also einem Herunterfahren der Magnetspuleneinrichtung, bei dem das Magnetfeld ganz oder teilweise abgeschaltet wird. Die Lasteinrichtung besitzt meist auch einen Wärmespeicher, der die von den Dioden oder Widerständen produzierte Wärme aufnimmt und speichert. Die Wärme kann gegebenenfalls aber auch direkt an das Gehäuse der äußeren Vakuumkammer abgegeben werden.

Erfindungsgemäß ist die Lasteinrichtung zumindest teilweise innerhalb der äußeren Vakuumkammer angeordnet. Dies bedeutet, dass sich beispielsweise die gesamte Lasteinrichtung zwischen Kryoschild und Vakuumkammer im Vakuum befindet. Optional kann aber beispielsweise auch die Dioden- bzw. Widerstandsanordnung innerhalb der Vakuumkammer (OVC) angeordnet sein und die erste Wärmespeichereinheit der ersten Lasteinrichtung außen an der Wand der Vakuumkammer. Dabei kann die Wärme der Dioden- bzw. Widerstandsanordnung die Wand der Vakuumkammer (OVC) zur ersten Wärmespeichereinheit durchdringen. Dadurch, dass die Lasteinrichtung zumindest teilweise innerhalb der äußeren Vakuumkammer angeordnet ist, besteht weniger Platzbedarf für die Lasteinrichtung außerhalb, wodurch das gesamte Magnetresonanzsystem kompakter gebaut werden kann.

Erfindungsgemäß weist das Magnetresonanzsystem einen Kühlkreislauf innerhalb der äußeren Vakuumkammer, an den die erste Lasteinrichtung zur Kühlung angeschlossen ist, und eine Steuereinheit auf, die dazu eingerichtet ist, den Kühlkreislauf nur dann in Betrieb zu setzen, wenn die erste Lasteinrichtung zum Herunterrampen genutzt wird.

In einem Ausführungsbeispiel ist vorgesehen, dass die erste Lasteinrichtung über einen thermischen Leiter mit einem Kaltkopf verbunden ist, welcher zur Kühlung der supraleitenden Magneteinrichtung eingesetzt ist. Ein derartiger Kaltkopf ist beispielsweise in der Druckschrift DE 11 2016 000 535 T5 beschrieben. Eine erste Stufe des Kaltkopfes kann zwischen der äußeren Vakuumkammer und dem Kryoschild die erste Lasteinrichtung kühlen. Dazu kann eine erste Stufe des Kaltkopfes über den thermischen Leiter mit der ersten Lasteinrichtung verbunden beziehungsweise thermisch gekoppelt sein. Mit der zweiten Stufe des Kaltkopfes können die supraleitenden Magnetspulen innerhalb des Kryoschilds auf beispielsweise 4 K gekühlt werden. Somit kann der eigentlich für die Kühlung der supraleitenden Magnetspulen verwendete Kaltkopf auch zur Kühlung der ersten Lasteinrichtung beispielsweise auf 50 K genutzt werden. Eine Verbesserung der thermischen Isolation nach innen hin kann durch Reduktion der mechanischen Verbindungen nach innen (also zum Kryoschild hin) erfolgen. Ein weitere Verbesserung der thermischen Isolation kann durch Ummantelung des Kryoschilds und/oder der äußeren Vakuumkammer mit einer Folie oder einer Struktur mit geringer Infrarotemissivität erreicht werden, um die Abstrahlung von Wärme zu reduzieren.

Gemäß einem weiteren Ausführungsbeispiel ist die supraleitende Magnetspuleneinrichtung, wie soeben beschrieben, in einem Kryoschild innerhalb der äußeren Vakuumkammer angeordnet. Der Kaltkopf ragt dabei durch die äußere Vakuumkammer und den Kryoschild hindurch, und die erste Lasteinrichtung ist zwischen der äußeren Vakuumkammer und dem Kryoschild über den thermischen Leiter mit dem Kaltkopf verbunden. Mit dem Kryoschild und der äußeren Vakuumkammer lassen sich im Wesentlichen drei Temperaturzonen voneinander abschirmen, nämlich eine äußere Temperaturzone mit etwa 300 K, eine mittlere Temperaturzone zwischen der äußeren Vakuumkammer und dem Kryoschild im Bereich von 50 K und eine innere Temperaturzone innerhalb des Kryoschilds mit etwa 4 K für die Supraleitung.

Bei einem weiteren Ausführungsbeispiel weist das Magnetresonanzsystem einen thermischen Schalter in dem thermischen Leiter auf, wobei mit dem thermischen Schalter eine Wärmeleitung des thermischen Leiters steuerbar ist. Der thermische Leiter koppelt die erste Lasteinrichtung und den Kaltkopf thermisch. Würde der thermische Schalter fehlen, könnte die Kühlung der ersten Lasteinrichtung nicht präzise gesteuert werden. Mit Hilfe des thermischen Schalters ist es möglich, die Kühlung der ersten Lasteinrichtung einzuschalten oder auszuschalten. Gegebenenfalls ist es mit dem thermischen Schalter sogar möglich, Zwischenzustände der thermischen Leitfähigkeit des thermischen Leiters einzustellen. Damit kann auch die Quantität der Kühlung reguliert werden. Der thermische Schalter ermöglicht es beispielsweise, beim Hochrampen des Magnetresonanzsystems zunächst die für die Supraleitung essentiellen Komponenten, nämlich die supraleitenden Magnetspulen zu kühlen und anschließend gegebenenfalls weitere Komponenten wie etwa die erste Lasteinrichtung (RDL).

In einem weiteren Ausführungsbeispiel ist vorgesehen, dass die erste Lasteinrichtung eine erste Diodenanordnung und/oder erste Widerstandsanordnung sowie eine erste Wärmespeichereinheit zur Aufnahme von Wärmeenergie von der ersten Diodenanordnung und/oder ersten Widerstandsanordnung aufweist. Bei der ersten Lasteinrichtung handelt es sich also um eine elektrische Last, die elektrischen Strom von der Magnetspuleneinrichtung in Wärme umsetzt. Hierzu eignen sich insbesondere Dioden und Widerstände. So kann die erste Lasteinrichtung beispielsweise eine Mehrzahl an Dioden und/oder Widerständen aufweisen, die in entsprechenden Anordnungen realisiert sind. Die erste Wärmespeichereinheit kann beispielsweise ganz oder teilweise aus Kupfer oder Aluminium gebildet sein. Diese Metalle besitzen eine verhältnismäßig hohe Wärmekapazität. Somit setzt die erste Lasteinrichtung nicht nur den anfallenden Strom in Wärme um, sondern speichert diese Wärme auch. Die erste Wärmespeichereinheit kann außen an der OVC angeordnet sein.

In einem anderen Ausführungsbeispiel besitzt das Magnetresonanzsystem neben der ersten Lasteinrichtung innerhalb der äußeren Vakuumkammer eine zweite Lasteinrichtung außerhalb der äußeren Vakuumkammer, wobei auch die zweite Lasteinrichtung eingerichtet ist zum Herunterrampen der supraleitenden Magnetspuleneinrichtung, indem elektrischer Strom von der Magnetspuleneinrichtung in die zweite Lasteinrichtung eingeleitet wird. Dies bedeutet, dass in diesem Fall der elektrische Strom der supraleitenden Magnetspulen nicht nur in die erste Lasteinrichtung, sondern auch in die zweite Lasteinrichtung eingeleitet werden kann. Insbesondere können beide Lasteinrichtungen gleichzeitig oder alternativ betrieben werden. Prinzipiell ist jede einzelne Lasteinrichtung dazu geeignet, das Herunterrampen der supraleitenden Magnetspuleneinrichtung zu ermöglichen, was jedoch entsprechend lang dauern könnte.

Werden beide Lasteinrichtungen gleichzeitig verwendet, kann das Herunterrampen schneller vonstattengehen. Dadurch, dass die Lasteinrichtungen in unterschiedlichen Temperaturzonen angeordnet sind (außerhalb und innerhalb der äußeren Vakuumkammer) können die Lasteinrichtungen selbst unterschiedlich gekühlt werden. Durch diese Varianz lässt sich die Ausfallsicherheit erhöhen.

In einer Weiterbildung kann vorgesehen sein, dass die zweite Lasteinrichtung eine zweite Diodenanordnung und/oder zweite Widerstandsanordnung sowie eine zweite Wärmespeichereinheit zur Aufnahme von Wärmeenergie von der zweiten Diodenanordnung und/oder zweiten Widerstandsanordnung aufweist, wobei die zweite Wärmespeichereinheit an ein separates Kühlsystem angeschlossen ist. Die zweite Lasteinrichtung kann prinzipiell aufgebaut sein wie die erste Lasteinrichtung. In der Regel genügt jedoch, wenn die zweite Wärmespeichereinheit beispielsweise als Kühlplatte ausgebildet ist. Diese lässt sich effizient durch das separate Kühlsystem kühlen. Dabei wird die zweite Wärmespeichereinheit beispielsweise von einem Kühlmedium durchströmt, oder es strömt daran vorbei.

In einem noch weiteren Ausführungsbeispiel kann vorgesehen sein, dass die erste und zweite Lasteinrichtung über eine Schalteinrichtung an supraleitende Spulen der supraleitenden Magnetspuleneinrichtung angeschlossen sind, so dass je nach Schaltzustand der Schalteinrichtung Strom der supraleitenden Spulen in die erste und/oder zweite Lasteinrichtung einleitbar ist. Diese Schalteinrichtung kann einen supraleitenden Schalter aufweisen. Er ist beispielsweise in der Lage, einen Strom von 500 bis 700 A zu schalten. Gegebenenfalls ist er auch in der Lage, den Strom auf beide Lasteinrichtungen aufzuteilen. Natürlich besitzt die Schalteinrichtung auch einen Schaltzustand, bei dem kein Strom aus den supraleitenden Spulen ausgeleitet wird.

Weiterhin kann vorgesehen sein, dass die erste Wärmespeichereinheit ein Material aufweist, das in einem innerhalb der äußeren Vakuumkammer vorgegebenen Temperaturbereich mindestens einen Phasenübergang besitzt. Wird beispielsweise der erste Wärmespeicher mit flüssigem Stickstoff gefüllt, kann der Phasenübergang des Stickstoffs für zusätzliche Wärmeaufnahme genutzt werden. Wird fester Stickstoff für den Wärmespeicher genutzt, können sogar zwei Phasenübergänge bei ca. 63 K und 77 K genutzt werden, um zusätzliche Energie aufzunehmen.

Gemäß einem weiteren Ausführungsbeispiel ist vorgesehen, dass die erste Lasteinrichtung unmittelbar an der äußeren Vakuumkammer befestigt ist. Die erste Lasteinrichtung kann also mechanisch an der äußeren Vakuumkammer abgestützt sein. Dabei ist es vorteilhaft, den Wärmeübergang der Abstützung beziehungsweise Befestigung möglichst effizient zu gestalten, so dass die erste Lasteinrichtung gegebenenfalls auch Wärme unmittelbar an die äußere Vakuumkammer beziehungsweise deren Wand abgeben kann. Sofern im vorliegenden Dokument von der "äußeren Vakuumkammer" die Rede ist, ist in der Regel die Wand dieser Vakuumkammer gemeint.

In einem weiteren Ausführungsbeispiel weist das Magnetresonanzsystem innerhalb der äußeren Vakuumkammer einen Kühlkreislauf auf, an dem die erste Lasteinrichtung zur Kühlung angeschlossen ist. Mit dem Kühlkreislauf lässt sich beispielsweise Wärme von der ersten Lasteinrichtung zum Kaltkopf abtransportieren. Es ist ein geeignetes Kühlmittel zu wählen, das in der Temperaturzone von etwa 50 K flüssig ist.

Erfindungsgemäß weist das Magnetresonanzsystem eine Steuereinrichtung auf, die dazu eingerichtet ist, den Kühlkreislauf nur dann in Betrieb zu setzen, wenn die erste Lasteinrichtung zum Herunterrampen genutzt wird. Dies bedeutet, dass die erste Lasteinrichtung nicht ständig über den Kühlkreislauf gekühlt wird. Dadurch kann der Energieverbrauch für eine Pumpe und deren Störpotential vermindert werden. Die Steuereinrichtung ist vielmehr in der Lage, nur dann den Kühlkreislauf in Betrieb zu setzen, wenn die Magnetspuleneinrichtung heruntergerampt werden soll und insbesondere nur dann, wenn auch die erste Lasteinrichtung zum Herunterrampen genutzt wird.

Die oben genannte Aufgabe wird erfindungsgemäß auch gelöst durch ein Verfahren zum Betreiben eines Magnetresonanzsystems gemäß Anspruch 11.

Die im Zusammenhang mit dem oben dargestellten Magnetresonanzsystem genannten Vorteile und Variationsmöglichkeiten gelten sinngemäß auch für das erfindungsgemäße Verfahren. In diesem Fall entsprechen die genannten funktionellen Merkmale des Magnetresonanzsystems korrespondierenden Verfahrensmerkmalen.

Für Anwendungsfälle oder Anwendungssituationen, die sich bei dem Verfahren ergeben können und die hier nicht explizit beschrieben sind, kann vorgesehen sein, dass gemäß dem Verfahren eine Fehlermeldung und/oder eine Aufforderung zur Eingabe einer Nutzerrückmeldung ausgegeben und/oder eine Standardeinstellung und/oder ein vorbestimmter Initialzustand eingestellt wird.

Die vorliegende Erfindung wird nun anhand der beigefügten Figuren erläutert. Es zeigen:
- FIG 1: eine schematische Ansicht eines Magnetresonanzsystems;
- FIG 2: eine schematische Ansicht von Komponenten eines Kühlsystems zur Kühlung supraleitender Magnetspulen eines Magnetresonanzsystems.

Die nachfolgend näher geschilderten Ausführungsbeispiele stellen bevorzugte Ausführungsformen der vorliegenden Erfindung dar. Dabei wird der von der Erfindung umfasste Schutzbereich durch die Ansprüche definiert.

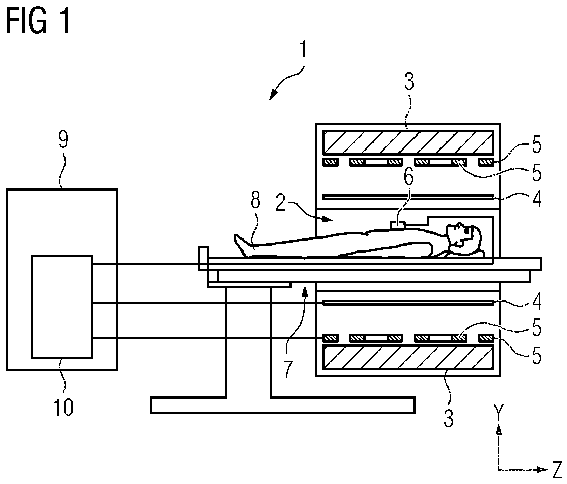

FIG 1 zeigt eine schematische Darstellung einer beispielhaften Ausführungsform eines MRT- bzw. Magnetresonanzsystems 1.

Das MRT-System 1 umfasst eine Magneteinheit mit einem Feldmagneten 3, der ein statisches Magnetfeld zur Ausrichtung von Kernspins eines Objekts 8, zum Beispiel eines Patienten, in einem Bildgebungsbereich erzeugt. Der Bildgebungsbereich ist durch ein äußerst homogenes statisches Magnetfeld gekennzeichnet, wobei sich die Homogenität insbesondere auf die Magnetfeldstärke beziehungsweise deren Amplitude bezieht. Der Bildgebungsbereich befindet sich in einem Patiententunnel 2, der sich in einer Längsrichtung Z durch die Magneteinheit erstreckt. Der Feldmagnet 3 kann beispielsweise ein supraleitender Magnet sein, der Magnetfelder mit einer magnetischen Flussdichte von bis zu 3 T oder mehr erzeugen kann. Für geringere Feldstärken können jedoch auch Permanentmagnete oder Elektromagnete mit normalleitenden Spulen verwendet werden. Ein Patiententisch 7 kann innerhalb des Patiententunnels 2 beweglich sein.

Weiterhin umfasst die Magneteinheit eine Gradientenspulenanordnung 5 mit mehreren Gradientenspulen, die dazu dienen, dem statischen Magnetfeld Gradientenfelder, also ortsabhängige Magnetfelder, in den drei Raumrichtungen zur räumlichen Differenzierung der abgetasteten Bildbereiche im Bildgebungsbereich zu überlagern. Die Gradientenspulen der Gradientenspulenanordnung 5 können zum Beispiel als Spulen aus normalleitenden Drähten ausgebildet sein, die zum Beispiel zueinander orthogonale Felder oder Feldgradienten im Bildgebungsbereich erzeugen können.

Die Magneteinheit umfasst eine Sendespulenanordnung, die beispielsweise eine Körperspule 4 als Sendeantenne umfassen kann, die dazu ausgebildet ist, ein Hochfrequenzsignal in den Bildgebungsbereich abzustrahlen. Die Körperspule 4 kann daher als HF-Sendespulenanordnung des MRT-Systems 1 verstanden werden oder als Teil der HF-Sendespulenanordnung. Die Körperspule 4 kann in einigen Ausführungsformen auch dazu verwendet werden, resonante MR-Signale zu empfangen, die von dem Objekt 8 ausgesendet werden. In diesem Fall kann die Körperspule 4 auch als Teil einer Signalerfassungsvorrichtung des MRT-Systems 1 betrachtet werden. Optional umfasst die Signalerfassungsvorrichtung eine lokale Spule 6, die in unmittelbarer Nähe des Objekts 8, zum Beispiel an dem Objekt 8 oder in dem Patiententisch 7, angeordnet sein kann. Die lokale Spule 6 kann alternativ oder zusätzlich zur Körperspule 4 als Empfangsspule beziehungsweise Empfangsantenne dienen.

Das MRT-System 1 umfasst auch ein Steuer- und Rechensystem 9. Das Steuer- und Rechensystem 9 kann eine Sende-Empfangssteuereinheit 10 umfassen, die mit der Körperspule 4, der Gradientenspulenanordnung 5 und/oder der lokalen Spule 6 verbunden ist. In Abhängigkeit von den erfassten MR-Signalen kann die Sende-Empfangssteuereinheit 10, die einen Analog-Digital-Wandler, ADC (englisch: "analog-to-digital converter") umfassen kann, entsprechende MR-Daten, insbesondere im k-Raum, erzeugen. Die Sende-Empfangssteuereinheit 10 ist gegebenenfalls auch mit der Körperspule 4 verbunden und steuert diese zur Erzeugung von HF-Impulsen, wie Anregungsimpulsen und/oder Refokussierungsimpulsen, an. Weiterhin kann die Sende-Empfangssteuereinheit 10 des Steuer- und Rechensystems 9 auch mit der Gradientenspulenanordnung 5 verbunden sein und diese steuern, um Schichtselektionsgradienten, Gradienten für die Frequenz- und/oder Phasencodierung und/oder Auslesegradienten zu schalten.

Ein Computer des Steuer- und Rechensystems 9 kann die MR-Daten auswerten und zum Beispiel eine Bildrekonstruktion oder Teile davon oder anderweitige Rechenaufgaben übernehmen, die im Zuge der Bildgebung notwendig sind. Es wird darauf hingewiesen, dass die beschriebene Struktur des Steuer- und Rechensystems 9 nur ein nicht begrenzendes Beispiel darstellt. Die verschiedenen erforderlichen Aufgaben und Funktionen können auch anders und/oder auf verschiedene Steuereinheiten und/oder andere Recheneinheiten verteilt sein.

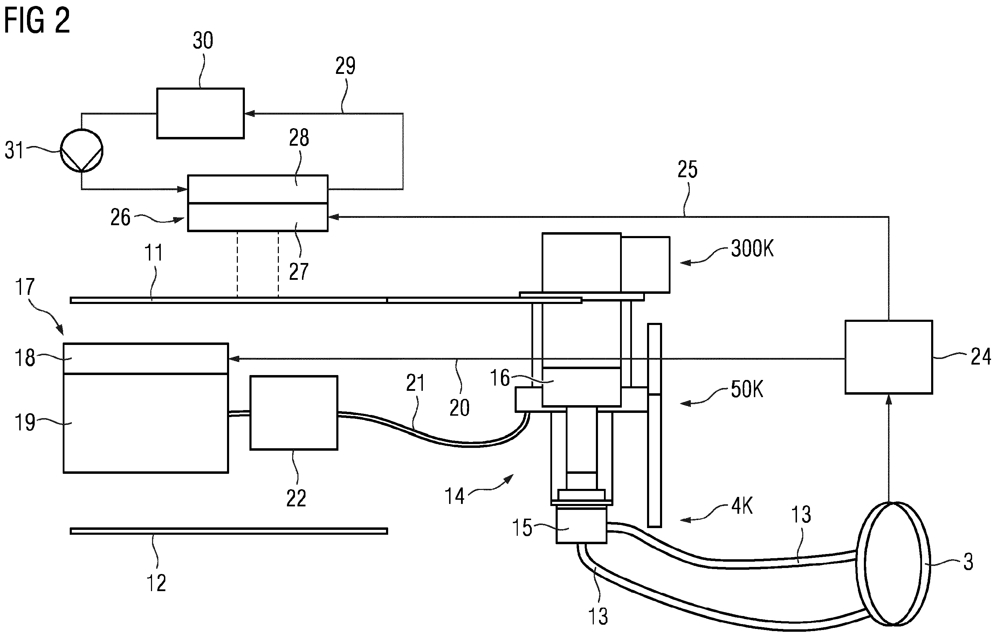

Das MRT-System 1 besitzt gemäß FIG 2 ein Kühlsystem, um die Magnetspulen 3 auf Temperaturen zu kühlen, bei denen diese supraleitend sind.

Das Kühlsystem des Magnetresonanzsystems besitzt im vorliegenden Beispiel im Wesentlichen drei Temperaturzonen. Die erste Temperaturzone ist in FIG 2 mit 300 K gekennzeichnet und symbolisiert in etwa die Umgebungstemperatur. Diese äußere Temperaturzone befindet sich außerdem einer äußeren Vakuumkammer 11. Innerhalb der äußeren Vakuumkammer 11 befinden sich die Magnetspulen 3, die von einem Kryoschild 12 umgeben sind. Zwischen dem Kryoschild 12 und der äußeren Vakuumkammer 11 befindet sich eine mittlere Temperaturzone, die in FIG 2 mit 50 K gekennzeichnet ist. Typischerweise liegt die Temperatur dort im Bereich von 40 bis 70 K.

Innerhalb des Kryoschilds 12, wo sich die Magnetspulen 3 befinden, liegt die innerste Temperaturzone, die in FIG 2 mit 4 K gekennzeichnet ist. In dieser Temperaturzone befindet sich ein Helium-Kühlkreislauf 13 zur Kühlung der Magnetspulen 3.

Die Kühlung wird im Wesentlichen durch einen Kaltkopf 14 realisiert. Der Kaltkopf 14 transportiert die Wärme vom Helium-Kühlkreislauf 13 innerhalb des Kryoschilds 12 nach außen durch die äußere Vakuumkammer 11. Dazu besitzt der Kaltkopf 14 eine zweite Kühlstufe 15, an die der Helium-Kühlkreislauf 13 angeschlossen ist. Im Vakuum zwischen der äußeren Vakuumkammer 11 und dem Kryoschild 12 befindet sich eine erste Kühlstufe 16 des Kaltkopfes 14. Mit dieser ersten Kühlstufe 16 kann beispielsweise auf 50 K herabgekühlt werden.

Innerhalb der äußeren Vakuumkammer 11 befindet sich auch eine erste Lasteinrichtung 17. Sie stellt eine elektrische Last dar und besitzt beispielsweise eine Diodenanordnung 18, die elektrischen Strom in Wärme wandeln kann. Um die Wärme abgeben zu können, ist die erste Diodenanordnung 18 auf einer ersten Wärmespeichereinheit 19 befestigt und mit dieser wärmeleitend verbunden. Die erste Lasteinrichtung 17 kann zur mechanischen Stützung und Wärmeabgabe auch an der äußeren Vakuumkammer 11 befestigt sein.

Die erste Lasteinrichtung 17 kann bei einem Herunterrampen (Run Down) der supraleitenden Magnetspulen 3 von diesen über eine erste Stromleitung 20 Strom aufnehmen. Bei der Wandlung des Stroms durch die erste Diodenanordnung 18 (alternativ oder zusätzlich auch eine Widerstandsanordnung) entsteht Wärme, die über den ersten Wärmespeicher 19, welcher an einen ersten Kühlkreislauf 21 angeschlossen ist, abgeführt wird.

Der erste Kühlkreislauf 21 ist an die erste Kühlstufe 16 des Kaltkopfes 14 angeschlossen. Optional kann der erste Kühlkreislauf 21 einen thermischen Schalter 22 aufweisen, mit dem der erste Kühlkreislauf 21 gesteuert beziehungsweise reguliert werden kann. Der erste Kühlkreislauf 21 kann auch alternativ als einfacher thermischer Leiter ausgebildet sein.

Beim Herunterrampen fließt der Strom aus den Magnetspulen 3 zunächst über eine Hauptleitung 23 zu einem elektrischen Schalter 24, der supraleitend sein kann. Der Schalter lenkt den Strom in die erste Stromleitung 20 oder eine zweite Stromleitung 25. Die zweite Stromleitung 25 führt aus der äußeren Vakuumkammer 11 heraus zu einer zweiten Lasteinrichtung 26. Mit dem Schalter 24 kann somit der Strom der supraleitenden Magnetspulen 3 entweder zur ersten Lasteinrichtung 17 oder zur zweiten Lasteinrichtung 26, gegebenenfalls aber auch zu beiden geschickt werden, um thermisch umgesetzt zu werden. Die zweite Lasteinrichtung 26 besitzt eine zweite Diodenanordnung 27, die den Strom von der zweiten Stromleitung 25 aufnimmt. Alternativ oder zusätzlich zu der zweiten Diodenanordnung kann die zweite Lasteinrichtung eine zweite Widerstandsanordnung besitzen. Außerdem besitzt die zweite Lasteinrichtung 26 eine zweite Wärmespeichereinheit 28. Die zweite Wärmespeichereinheit 28 kann als Kühlplatte realisiert sein. Vorzugsweise ist diese an einen zweiten Kühlkreislauf 29 mit separatem Wärmetauscher 30 und Pumpe 31 angeschlossen.

Das dargestellte Kühlsystem ist aufgrund der Komplexität durchaus anfällig gegenüber Störungen, die auch unterschiedlich häufig vorkommen können. So treten beispielsweise die folgenden Betriebssituationen auf:
Betriebssituation 1: Die Wasserkühlung (in FIG 2 nicht eingezeichnet; kühlt den Kaltkopf 14) des Systems fällt wegen eines Fehlers des Kühlsystems (z. B. Pumpe) oder wegen Stromausfalls ohne eine USV-Pufferung (unterbrechungsfreie Stromversorgung) aus. Damit fällt auch die Magnetkühlung aus und gleichzeitig kann beim Herunterfahren des Systems die Wärme aus der ersten Lasteinrichtung 17 (RDL) nicht abtransportiert werden, da ja der Kaltkopf 14 wegen der mangelnden Wasserzirkulation nicht läuft. Die Energie des Magneten beziehungsweise der Magnetspulen 3 muss komplett in der ersten Lasteinrichtung 17 (z. B. bei 50 K) deponiert werden und muss diesem beim Rückkühlen wieder entzogen werden.

Betriebssituation 2: Die Magnetkühlung fällt aus wegen eines Fehlers des Kompressors (MREF) der in FIG 2 nicht eingezeichneten primären Kühlvorrichtung, die an den Kaltkopf 14 angeschlossen ist. Aber die Wasserkühlung in dem zweiten Kühlkreislauf 29 läuft weiter durch die zweite Lasteinrichtung 26. Die Energie der supraleitenden Magnetspulen 3 kann durch die Wasserzirkulation abgeführt werden und die zweite Lasteinrichtung 26 muss nicht die gesamte Energie speichern. Alle Energie wird außerhalb des eigentlichen Magnetresonanzsystems deponiert. Ein Rückkühlen der ersten Lasteinrichtung 17 für Fehlerfälle, in denen der Kompressor beziehungsweise Kaltkopf 14 ausfällt, aber die Wasserkühlung weiterläuft, ist nicht erforderlich.

Gegenüber üblichen "Run Down Loads" (Lasteinrichtungen) kann eine signifikante Verkleinerung und eine Reduktion des Platzbedarfs außen am Magnetresonanzsystem durch Integration der ersten Lasteinrichtung 17 in die äußere Vakuumkammer 11 erreicht werden. Dabei kann eine thermische Ankopplung der ersten Lasteinrichtung 17 an die erste Stufe des Kaltkopfes 14, der im thermischen Gleichgewicht eine Temperatur von ca. 40 bis 70 K erreicht, erfolgen. Der supraleitende Schalter 24 des Magnetresonanzsystems kann so geöffnet werden, dass der Strom aus dem Hauptmagnetfeld über das Dioden-/ Widerstandsarray 18 oder 27 geführt wird und die Energie des statischen Magnetfelds dadurch in Wärme umgewandelt wird. Das Diodenarray 18 beziehungsweise 27 sitzt auf einer jeweiligen Wärmespeichereinheit 19, 28, die diese Energie zwischenspeichert, bis sie abgeführt wird. Dieses Abführen der Energie kann mittels Luft, Wasser oder anderen Kühlmaßnahmen erfolgen. Insbesondere können Heatpipes verwendet werden.

Wie erwähnt ist die erste Lasteinrichtung 17 im Inneren der äußeren Vakuumkammer 11 angeordnet. Sie ist thermisch mit der ersten Stufe des Kaltkopfes 14 verbunden. Im Hinblick auf die Machbarkeit kann geschätzt werden, dass die erste Stufe des Kaltkopfes 14 ca. 60 W Kälteleistung bei ca. 70 K Temperatur erzeugt. Um 12 MJ Energie aus der ersten Lasteinrichtung 17 mit 60 W Leistung zu entziehen, dauert es 12 MJ/60/3600 s = 55 h (ohne Berücksichtigung der Temperaturabhängigkeit der Wärmekapazität und ohne die Berücksichtigung, dass der Kaltkopf 14 bei höherer Temperatur mehr Kälteleistung hat). Dies würde den Magneten nach einem Herunterfahren beziehungsweise Herunterrampen deutlich schneller wieder einsatzfähig machen als bei einem Quench. Eine signifikante Abnahme der Wärmekapazität von Aluminium beginnt erst ab ca. 100 bis 150 K. Das bedeutet, dass zur Erhöhung auf 290 K ein dT = 140 K mit voller Wärmekapazität zur Verfügung steht. Die Masse der Wärmespeichereinheit 19 aus Aluminium könnte also sein: 12 MJ/(0,8 kJ/K/W)/140 K = 100 kg. Faktisch kann der Puffer beziehungsweise die Wärmespeichereinheit noch kleiner sein, da in der Rechnung angenommen wurde, dass die Lasteinrichtung zwischen 70 bis 150 K keine Wärmekapazität hat.

Die Lasteinrichtungen beziehungsweise deren Wärmespeichereinheiten können mit Aluminium, Kupfer, Stahl oder anderen Materialien mit hoher Wärmekapazität realisiert werden. Insbesondere kann auch flüssiger Stickstoff oder Helium sowie Kombinationen all der genannten Materialien verwendet werden.

Die erste Lasteinrichtung 17 ist optional mit dem Kaltkopf 14 über den thermischen Schalter 22 verbunden. Der thermische Schalter 22 kann auf der Magnetelektronik oder vom System gesteuert werden. Er erlaubt, wie erwähnt, ein Ein-/Ausschalten oder Zwischenzustände des Wärmeübergangs.

Zusätzlich zu der ersten Lasteinrichtung im Inneren der äußeren Vakuumkammer 11, die auf ca. 50 K abgekühlt werden kann, existiert hier eine zweite, externe Lasteinrichtung 26. Diese zweite Lasteinrichtung 26 kann sehr klein gewählt werden (z. B. nur wenige Kilogramm; kleiner 1 bis 30 Kilogramm). Sie enthält ebenfalls eine Widerstands- beziehungsweise Diodenanordnung 27 und dient in erster Linie zur Wärmeübertragung an ein vorbeiströmendes Kühlmedium (z. B. Wasser, Luft). In einer vereinfachten Ausgestaltung genügt als zweite Lasteinrichtung eine Kühlplatte mit einem Diodenpaket.

Während des Betriebs kann die zentrale Steuereinheit des Magnetresonanzsystems im Falle eines notwendigen Herunterfahrens beispielsweise erkennen, ob die Wasserzirkulation der primären Kühlvorrichtung (in FIG 2 nicht dargestellt) noch funktioniert oder nicht. Sie kann damit die beiden oben dargestellten Betriebssituationen 1 und 2 unterscheiden. Im Falle eines Fehlers wie in der Betriebssituation 1 wird die zentrale Steuereinheit des Magnetresonanzsystems die erste Lasteinrichtung aktivieren. Im Falle eines Fehlers wie in der Betriebssituation 2 wird die zweite Lasteinrichtung aktiviert. In vorteilhafter Weise wird dadurch die Verfügbarkeit des Systems erhöht, da die lange Rückkühlzeit von ca. 55 h nur im Fall von Betriebssituation 1 nötig ist. Im Fall von Betriebssituation 2 ist der Magnet immer noch kalt und kann direkt wieder hochgerampt werden, wenn der Fehler beseitigt wurde.

Der thermische Schalter 22 ermöglicht es, z. B. beim Abkühlen des Magneten erst alle kritischen Komponenten abzukühlen, die das Hochrampen des Magneten erlauben und die erste Lasteinrichtung dann erst nachträglich herunter zu kühlen. Die Wahrscheinlichkeit, dass genau in diesen 50 h ein Fehlerfall eintritt, der dazu führt, dass die erste Lasteinrichtung benötigt würde, ist tolerierbar. Der thermische Schalter kann auch während des Betriebs meist offenbleiben. Alternativ kann er während eines Herunterfahrens des Magneten geöffnet werden, wenn dies vorteilhaft erscheint.

Es können so genannte hybride kryogene Wärmespeichereinheiten verwendet werden. In einer Variante kann als Speichermaterial flüssiger Stickstoff verwendet werden. Der entsprechende hybride Wärmespeicher kann aus einer metallischen Hülle und einem Inhalt bestehen, der bei Erwärmung einen Phasenübergang vollzieht. Im vorliegenden Fall besteht die Füllung aus flüssigem Stickstoff. Dieser besitzt mit einer Wärmekapazität von ca. 2 kJ/kg/K nur eine geringfügig höhere Wärmekapazität wie z. B. Aluminium mit 0,88 kJ/kg/K. Zusätzlich benötigt der flüssige Stickstoff für den Phasenübergang eine Energie von 200 kJ/kg. Bei 10 kg Stickstoff würde ein Volumen von 20 m³ bei Raumtemperatur entstehen. Bei 200 Bar Druck könnte das in einem 200 l Gefäß realisiert werden. Dies liefert mit 2000 kJ jedoch nur knapp 20 Prozent des benötigten Energiespeichers für einen 3 T-Magneten.

Bei einer alternativen Realisierung ist auch denkbar, dass als kryogener Kältespeicher fester Stickstoff verwendet wird. Dadurch sind beide Phasenübergänge bei ca. 63 K und 77 K nutzbar. Das sind weitere 25 kJ/kg/K bei Stickstoff.

Bei einer alternativen Variante wird Helium als kryogener Wärmespeicher genutzt. Das Magnetresonanzsystem benötigt in aller Regel ohnehin ein Druckgefäß zum Speichern des Heliums im Falle eines Quenches oder der Erwärmung des gesamten Magneten. Das Druckgefäß ist heute auch außerhalb der äußeren Vakuumkammer (OVC) angebracht und könnte ebenfalls im Zwischenraum zwischen OVC und Kryoschild platziert werden. Damit kann weiterer Platz außerhalb des OVC eingespart werden, und die Leitungslängen und Durchführungen der Heliumleitungen durch den OVC können einspart werden. Dieses Druckgefäß muss (bei 20 bis 200 Bar) mit großer Wanddicke versehen werden. Denkbar ist daher, dass das Druckgefäß gleichzeitig als hybrider RDL genutzt wird. Neben der höheren Wärmekapazität von Helium gegenüber Stickstoff hat Helium somit auch den Vorteil, dass Synergien genutzt werden können, denn das Druckgefäß kann so zwei Funktionen übernehmen (Helium speichern, und im Falle eines kontrollierten Herunterrampens Wärme speichern).

Das Kühlsystem wurde oben stets mit zwei Lasteinrichtungen 17 und 26 beschrieben. Die Erfindung lässt sich aber auch nur mit der ersten Lasteinrichtung 17 innerhalb der Vakuumkammer 11 realisieren. Optional ist eine Realisierung mit beiden Lasteinrichtungen möglich.

Der besondere Vorteil der erfindungsgemäßen kryotechnischen Anordnung der Lasteinrichtung beziehungsweise des Wärmespeichers für das Herunterfahren von "trockenen Magneten" liegt in geringem Platzbedarf, geringeren Kosten und einer höheren Integration der Lasteinrichtung (RDL) in das Magnetresonanzsystem sowie gegebenenfalls der Nutzung von Synergien zwischen der Lasteinrichtung und dem Heliumspeicher.

## Patentansprüche

1. Magnetresonanzsystem (1) mit
- einer supraleitenden Magnetspuleneinrichtung (3),
- einer äußeren Vakuumkammer (11), in der die supraleitende Magnetspuleneinrichtung (3) angeordnet ist, und
- einer ersten Lasteinrichtung (17) zum Herunterrampen der supraleitenden Magnetspuleneinrichtung (3), indem elektrischer Strom von der Magnetspuleneinrichtung (3) in die erste Lasteinrichtung (17) eingeleitet wird, wobei die erste Lasteinrichtung (17) zumindest teilweise innerhalb der äußeren Vakuumkammer (11) angeordnet ist, wobei das Magnetresonanzsystem einen Kühlkreislauf innerhalb der äußeren Vakuumkammer (11) aufweist, an den die erste Lasteinrichtung (17) zur Kühlung angeschlossen ist, **dadurch gekennzeichnet, dass** das Magnetresonanzsystem eine Steuereinrichtung aufweist, die dazu eingerichtet ist, den Kühlkreislauf nur dann in Betrieb zu setzen, wenn die erste Lasteinrichtung (17) zum Herunterrampen genutzt wird.

2. Magnetresonanzsystem (1) nach Anspruch 1, wobei die erste Lasteinrichtung (17) über einen thermischen Leiter (21) mit einem Kaltkopf (14) verbunden ist, welcher zur Kühlung der supraleitenden Magneteinrichtung (3) eingesetzt ist.

3. Magnetresonanzsystem (1) nach Anspruch 2, wobei die supraleitende Magnetspuleneinrichtung (3) in einem Kryoschild (12) innerhalb der äußeren Vakuumkammer (11) angeordnet ist, der Kaltkopf (14) durch die äußere Vakuumkammer (11) und den Kryoschild (12) hindurchragt, und die erste Lasteinrichtung (17) zwischen der äußeren Vakuumkammer (11) und dem Kryoschild (12) über den thermischen Leiter (21) mit dem Kaltkopf (14) verbunden ist.

4. Magnetresonanzsystem (1) nach Anspruch 2 oder 3, das einen thermischen Schalter (22) in dem thermischen Leiter (21) aufweist, wobei mit dem thermischen Schalter (22) eine Wärmeleitung des thermischen Leiters (21) steuerbar ist.

5. Magnetresonanzsystem (1) nach einem der vorhergehenden Ansprüche, wobei die erste Lasteinrichtung (17) eine erste Diodenanordnung (18) und/oder Widerstandsanordnung sowie eine erste Wärmespeichereinheit (19) zur Aufnahme von Wärmeenergie von der ersten Diodenanordnung (18) und/oder Widerstandsanordnung aufweist.

6. Magnetresonanzsystem (1) nach einem der vorhergehenden Ansprüche, das neben der ersten Lasteinrichtung (17) innerhalb der äußeren Vakuumkammer (11) eine zweite Lasteinrichtung (26) außerhalb der äußeren Vakuumkammer (11) besitzt, wobei auch die zweite Lasteinrichtung (26) eingerichtet ist zum Herunterrampen der supraleitenden Magnetspuleneinrichtung (3), indem elektrischer Strom von der Magnetspuleneinrichtung (3) in die zweite Lasteinrichtung (26) eingeleitet wird.

7. Magnetresonanzsystem (1) nach Anspruch 6, wobei die zweite Lasteinrichtung (26) eine zweite Diodenanordnung (27) und/oder zweite Widerstandsanordnung sowie eine zweite Wärmespeichereinheit (28) zur Aufnahme von Wärmeenergie von der zweiten Diodenanordnung (27) und/oder zweiten Widerstandsanordnung aufweist, und wobei die zweite Wärmespeichereinheit (28) an ein separates Kühlsystem (29) angeschlossen ist.

8. Magnetresonanzsystem (1) nach Anspruch 6 oder 7, wobei die erste und zweite Lasteinrichtung über eine Schalteinrichtung (24) an supraleitende Spulen der supraleitenden Magnetspuleneinrichtung (3) angeschlossen sind, so dass je nach Schaltzustand der Schalteinrichtung (24) Strom der supraleitenden Spulen in die erste und/oder zweite Lasteinrichtung einleitbar ist.

9. Magnetresonanzsystem (1) nach einem der Ansprüche 5 bis 8, wobei die erste Wärmespeichereinheit (19) ein Material aufweist, das in einem innerhalb der äußeren Vakuumkammer (11) vorgegebenen Temperaturbereich mindestens einen Phasenübergang besitzt.

10. Magnetresonanzsystem (1) nach einem der vorhergehenden Ansprüche, wobei die erste Lasteinrichtung (17) unmittelbar an der äußeren Vakuumkammer (11) befestigt ist.

11. Verfahren zum Betreiben eines Magnetresonanzsystems (1), das eine supraleitende Magnetspuleneinrichtung (3), eine äußere Vakuumkammer (11), in der die supraleitende Magnetspuleneinrichtung (3) angeordnet ist, eine erste Lasteinrichtung (17) zum Herunterrampen der supraleitenden Magnetspuleneinrichtung (3), die zumindest teilweise innerhalb der äußeren Vakuumkammer (11) angeordnet ist, einen Kühlkreislauf innerhalb der äußeren Vakuumkammer, an den die erste Lasteinrichtung (17) zur Kühlung angeschlossen ist, und eine Steuereinrichtung aufweist, wobei -elektrischer Strom innerhalb der äußeren Vakuumkammer (11) von der Magnetspuleneinrichtung (3) in die erste Lasteinrichtung eingeleitet wird, **dadurch gekennzeichnet, dass** die Steuereinrichtung den Kühlkreislauf nur dann in Betrieb setzt, wenn die erste Lasteinrichtung (17) zum Herunterrampen genutzt wird.

## Claims

1. Magnetic resonance system (1) having
- a superconducting magnetic coil facility (3),
- an outer vacuum chamber (11) in which the superconducting magnetic coil facility (3) is arranged, and
- a first load facility (17) for ramping down the superconducting magnetic coil facility (3), in that electrical current is introduced from the magnetic coil facility (3) into the first load facility (17),
wherein
- the first load facility (17) is arranged at least in part within the outer vacuum chamber (11), wherein the magnetic resonance system has a cooling circuit within the outer vacuum chamber (11), to which the first load facility (17) is connected for cooling,
**characterised in that**
- the magnetic resonance system has a control facility, which is configured to only set the cooling circuit into operation when the first load facility (17) is used for the ramping down.

2. Magnetic resonance system (1) according to claim 1, wherein the first load facility (17) is connected to a cold head (14) via a thermal conductor (21) which is used for cooling the superconducting magnetic facility (3).

3. Magnetic resonance system (1) according to claim 2, wherein the superconducting magnetic coil facility (3) is arranged in a cryoschield (12) within the outer vacuum chamber (11), the cold head (14) protrudes through the outer vacuum chamber (11) and the cryoshield (12), and the first load facility (17) is connected between the outer vacuum chamber (11) and the cryoshield (12) via the thermal conductor (21) to the cold head (14).

4. Magnetic resonance system (1) according to claim 2 or 3, which has a thermal switch (22) in the thermal conductor (21), wherein it is possible using the thermal switch (22) to control heat dissipation of the thermal conductor (21).

5. Magnetic resonance system (1) according to one of the preceding claims,
wherein the first load facility (17) has a first diode arrangement (18) and/or resistor arrangement and a first heat storage unit (19) for receiving thermal energy from the first diode arrangement (18) and/or resistor arrangement.

6. Magnetic resonance system (1) according to one of the preceding claims, which in addition to the first load facility (17) within the outer vacuum chamber (11) has a second load facility (26) outside the outer vacuum chamber (11), wherein the second load facility (26) is also configured so as to ramp down the superconducting magnetic coil facility (3) in that electrical current is introduced from the magnetic coil facility (3) into the second load facility (26).

7. Magnetic resonance system (1) according to claim 6, wherein the second load facility (26) has a second diode arrangement (27) and/or second resistor arrangement and also a second heat storage unit (28) for receiving thermal energy from the second diode arrangement (27) and/or second resistor arrangement, and wherein the second heat storage unit (28) is connected to a separate cooling system (29).

8. Magnetic resonance system (1) according to claim 6 or 7, wherein the first and second load facility are connected via a switching facility (24) to superconducting coils of the superconducting magnetic coil facility (3) so that depending upon the switching state of the switching facility (24) current of the superconducting coils can be introduced into the first and/or second load facility.

9. Magnetic resonance system (1) according to one of claims 5 to 8, wherein the first heat storage unit (19) has a material which in a temperature range which is predetermined within the outer vacuum chamber (11) has at least one phase transition.

10. Magnetic resonance system (1) according to one of the preceding claims, wherein the first load facility (17) is fastened directly to the outer vacuum chamber (11).

11. Method for operating a magnetic resonance system (1) which has a superconducting magnetic coil facility (3), an outer vacuum chamber (11) in which the superconducting magnetic coil facility (3) is arranged, a first load facility (17) for ramping down the superconducting magnetic coil facility (3) which is arranged at least in part within the outer vacuum chamber (11), a cooling circuit within the outer vacuum chamber, to which the first load facility (17) is connected for cooling, and a control facility, wherein
- electrical current within the outer vacuum chamber (11) is introduced from the magnetic coil facility (3) into the first load facility,
**characterised in that**
- the control facility only sets the cooling circuit into operation when the first load facility (17) is used for the ramping down.

## Revendications

1. Système (1) de résonance magnétique comprenant
- un dispositif (3) supraconducteur à bobine d'électroaimant,
- une chambre (11) à vide extérieure, dans laquelle le dispositif (3) supraconducteur à bobine d'électro-aimant est disposé, et
- un premier dispositif (17) de charge pour abaisser en rampe le dispositif (3) supraconducteur à bobine d'électro-aimant, en envoyant du courant électrique du dispositif (3) à bobine d'électro-aimant au premier dispositif (17) de charge, dans lequel le premier dispositif (17) de charge est disposé au moins en partie dans la chambre (11) à vide extérieure, dans lequel le système de résonance magnétique a un circuit de refroidissement dans la chambre (11) à vide extérieure, auquel le premier dispositif (17) de charge est raccordé pour le refroidissement,
**caractérisé en ce que** le système de résonance magnétique a un dispositif de commande, qui est agencé pour ne mettre en fonctionnement le circuit de refroidissement que si le premier dispositif (17) de charge est utilisé pour l'abaissement en rampe.

2. Système (1) de résonance magnétique suivant la revendication 1, dans lequel le premier dispositif (17) de charge est, par un conducteur (21) thermique, relié à une tête (14) de charge, qui est utilisée pour le refroidissement du dispositif (3) magnétique supraconducteur.

3. Système (1) de résonance magnétique suivant la revendication 2, dans lequel le dispositif (3) supraconducteur à bobine d'électro-aimant est disposé dans un cryobouclier (12) à l'intérieur de la chambre (11) sous vide extérieure, la tête (14) froide traverse la chambre (11) à vide extérieure et le cryobouclier (12) et le premier dispositif (17) de charge est, entre la chambre (11) à vide extérieure et le cryobouclier (12), relié à la tête (14) froide par le conducteur (21) thermique.

4. Système (1) de résonance magnétique suivant la revendication 2 ou 3, qui a un interrupteur (22) thermique dans le conducteur (21) thermique, dans lequel une conduction de chaleur du conducteur (21) thermique peut être commandée par l'interrupteur (22) thermique.

5. Système (1) de résonance magnétique suivant l'une des revendications précédentes, dans lequel le premier dispositif (17) de charge a un premier agencement (18) de diode et/ou agencement de résistance ainsi qu'une première unité (19) d'accumulation de chaleur pour l'absorption d'énergie calorifique par le premier agencement (18) de diode et/ou l'agencement de résistance.

6. Système (1) de résonance magnétique suivant l'une des revendications précédentes, qui possède, outre le premier dispositif (17) de charge dans la chambre (11) à vide extérieure, un deuxième dispositif (26) de charge à l'extérieur de la chambre (11) à vide extérieure, dans lequel le deuxième dispositif (26) de charge est agencé également pour abaisser en rampe le dispositif (3) supraconducteur à bobine d'électro-aimant en envoyant du courant électrique du dispositif (3) supraconducteur à bobine d'électro-aimant au deuxième dispositif (26) de charge.

7. Système (1) de résonance magnétique suivant la revendication 6, dans lequel le deuxième dispositif (26) de charge a un deuxième agencement (27) de diode et/ou deuxième agencement de résistance ainsi qu'une deuxième unité (28) d'accumulation de la chaleur pour l'absorption d'énergie calorifique par le deuxième agencement (27) de diode et/ou deuxième agencement de résistance, et dans lequel la deuxième unité (28) d'accumulation de chaleur est raccordée à un système (29) distinct de refroidissement.

8. Système (1) de résonance magnétique suivant la revendication 6 ou 7, dans lequel le premier et le deuxième dispositifs de charge sont raccordés par un dispositif (24) de commutation à des bobines supraconductrices du dispositif (3) supraconducteur à bobine d'électro-aimant, de manière à ce que, suivant l'état de commutation du dispositif (24) de commutation, du courant puisse être envoyé des bobines supraconductrices au premier et/ou au deuxième dispositifs de charge.

9. Système (1) de résonance magnétique suivant l'une des revendications 5 à 8, dans lequel la première unité (19) d'accumulation de chaleur comporte un matériau, qui possède au moins une transition de phase dans une plage de température donnée à l'avance à l'intérieur de la chambre (11) à vide extérieure.

10. Système (1) de résonance magnétique suivant l'une des revendications précédentes, dans lequel le premier dispositif (17) de charge est fixé directement à la chambre (11) à vide extérieure.

11. Procédé pour faire fonctionner un système (1) de résonance magnétique, qui a un dispositif (3) supraconducteur à bobine d'électro-aimant, une chambre (11) à vide extérieure, qui est disposée dans le dispositif (3) supraconducteur à bobine d'électro-aimant, un premier dispositif (17) de charge pour abaisser en rampe le dispositif (3) supraconducteur à bobine d'électro-aimant et qui est disposé au moins en partie dans la chambre (11) à vide extérieure, un circuit de refroidissement dans la chambre à vide extérieure, auquel est raccordé, pour le refroidissement, le premier dispositif (17) de charge et un dispositif de commande,
dans lequel
on envoie du courant électrique à l'intérieur de la chambre (11) à vide extérieure du dispositif (3) à bobine d'électro-aimant au premier dispositif de charge,
**caractérisé en ce que**
le dispositif de commande ne met en fonctionnement le circuit de refroidissement que si le premier dispositif (17) de charge est utilisé pour l'abaissement en rampe.
